# FASCICULE DE BREVET EUROPEEN

(11) **EP 4 679 983 B1**
(45) Date de publication et mention de la délivrance du brevet: **19.08.2026**
(21) Numéro de dépôt: 25186963.2
(22) Date de dépôt: 02.07.2025
(51) Int. Cl.: H10H 29/01, H10H 29/14, H10H 20/01, H10H 20/815, H10H 20/817, H10H 20/819, H10H 20/825, H10H 29/30, H10H 29/80, H10H 20/81

(54) **PROCÉDÉ DE FABRICATION D'UN DISPOSITIF PHOTONIQUE ET DISPOSITIF PHOTONIQUE CORRESPONDANT**
VERFAHREN ZUR HERSTELLUNG EINER PHOTONISCHEN VORRICHTUNG UND ENTSPRECHENDE PHOTONISCHE VORRICHTUNG
METHOD OF MANUFACTURING A PHOTONIC DEVICE AND CORRESPONDING PHOTONIC DEVICE

(30) Priorité: 11.07.2024 FR 2407586
(43) Date de publication de la demande: 14.01.2026
(73) Titulaire: Commissariat à l'Energie Atomique et aux Energies Alternatives, 75015 Paris (FR)
(72) Inventeur: AUDIBERT, Margaux, 38054 GRENOBLE CEDEX 09 (FR); DUSSAIGNE, Amélie, 38054 GRENOBLE CEDEX 09 (FR); VEUX, Guillaume, 38054 GRENOBLE CEDEX 09 (FR)
(74) Mandataire: Cabinet Beaumont

(56) Documents cités:
- US-A1- 2022 209 066
- US-A1- 2022 406 968
- US-A1- 2024 072 100
- US-A1- 2024 186 444

## Description

### Domaine technique

La présente description concerne de façon générale le domaine général des dispositifs photoniques, et plus particulièrement les micro-écrans couleur à émissions natives rouge, vert, bleu ainsi que les dispositifs infrarouges à ondes courtes.

L'invention concerne de tels dispositifs photoniques ainsi que leurs procédés de fabrication.

### Technique antérieure

Les micro-écrans couleurs comprennent des pixels formés de sous-pixels bleus, verts et rouges (pixels RGB). Dans la suite de la description, ces sous-pixels seront désignés plus simplement pixels par souci de concision.

Les pixels bleus et verts peuvent être fabriqués à base de matériaux nitrures et les pixels rouges à base de matériaux phosphures. Pour combiner sur le même substrat ces trois types de pixels, la technique dite de « pick and place » est généralement utilisée. Cependant, dans le cas des micro-écrans avec des pixels inférieurs à 10 µm, cette technique ne peut plus être utilisée à cause, notamment, des problèmes d'alignement. Pour les écrans avec un grand nombre de pixels (définition élevée), cette technique de « pick and place » est problématique en termes de temps. De plus il faut prélever les pixels sur des plaques ('wafer') différentes, ce qui nécessite plusieurs transferts successifs. Des techniques de transfert en parallèle peuvent également être utilisées ('mass transfer').

Une autre solution consiste à réaliser la conversion de couleurs avec des boîtes quantiques (QD pour « Quantum Dot » en langue anglaise) ou des nanophosphores pompés par des µLEDs bleues issues d'une seule plaque ('wafer'), soit reportés, soit dans une matrice monolithique (cas préféré pour les micro-écrans). Cependant, le contrôle du dépôt de ces matériaux sur des pixels de faibles dimensions est difficile et leur tenue au flux n'est pas suffisamment robuste.

Il est donc crucial de pouvoir obtenir les trois pixels RGB de façon native avec la même famille de matériaux et dont la croissance est réalisée sur le même substrat. Pour cela, l'InGaN est le matériau le plus prometteur. Ce matériau peut, en effet, théoriquement couvrir tout le spectre visible en fonction de sa concentration en indium. Les micro-LEDs bleues à base d'InGaN montrent déjà une luminance élevée, bien supérieure à leurs homologues organiques. Pour émettre à des longueurs d'onde dans le vert, les puits quantiques (PQs) de la LED doivent contenir au moins 25% d'indium et pour une émission dans le rouge, il est nécessaire d'avoir au moins 35% d'indium. Malheureusement, la qualité du matériau InGaN au-delà de 20% d'In est dégradée en raison de la faible miscibilité de l'InN dans le GaN, mais aussi en raison de la forte contrainte compressive inhérente à la croissance de la zone active InGaN sur GaN.

Il est donc essentiel de pouvoir réduire la contrainte globale dans les structures à base de GaN/InGaN.

Actuellement, une des solutions les plus prometteuses consiste à porosifier la couche de GaN des mésas par voie électrochimique, comme décrit par exemple, dans les deux articles de Pasayat et al. (Materials 2020, 13, 213 et Appl. Phys. Express 2021, 14, 011004).

La couche porosifiée de GaN ainsi obtenue peut permettre de faire croître une structure LED nitrure à base d'InGaN, grâce à la relaxation des mesas poreux générés. Cependant, seule l'émission dans le rouge a été observée.

Récemment, il a été montré qu'une relaxation de la couche d'InGaN précédant les puits quantiques était avantageuse pour augmenter le taux d'incorporation d'In de ces derniers. Plus la couche InGaN inférieure est relaxée et plus le taux d'incorporation de l'In est élevé dans la couche supérieure (EP 3840065 A1 et EP 3840016 A1). En fonction de la quantité d'indium incorporée dans les puits quantiques à base d'InGaN, différentes longueurs d'onde émises peuvent être obtenues.

À l'heure actuelle, cette modification de la concentration en indium est contrôlée au cours de l'épitaxie et/ou par le paramètre de maille a du substrat. Pour obtenir différentes longueurs d'onde, il faut donc réaliser soit plusieurs épitaxies successives soit avoir des mésas présentant différents paramètres de maille a sur le même substrat.

Cependant, pour obtenir l'émission rouge, il est nécessaire d'atteindre un très grand paramètre de maille dans le plan (typiquement 3,238 Å). Or, un tel paramètre de maille est difficile à atteindre.

Les documents US 2024/0186444 A1, US 2024/0072100 A1, US 2022/0406968 A1 et US 2022/0209066 A1 décrivent des procédés de fabrication de dispositifs émettant dans le rouge, le vert et le bleu, à base de semi-conducteurs en nitrures d'éléments du groupe III rendus poreux, ainsi que les dispositifs correspondants.

### Résumé de l'invention

Il existe un besoin de proposer un procédé de fabrication d'un dispositif photonique permettant d'obtenir des pixels ayant différentes longueurs d'onde, dont au moins une longueur d'onde est, de préférence, dans le rouge voire dans l'infrarouge court.

Ce but est atteint par un procédé, selon la revendication 1 en annexe, de fabrication d'un dispositif photonique comprenant les étapes suivantes :
- fournir une structure comprenant un substrat de base recouvert par des mésas (Al,In,Ga)N/(Al,In,Ga)N, une première mésa étant entièrement porosifiée et ayant des flancs recouverts par une couche de protection, une deuxième mésa étant non porosifiée et une troisième mésa comprenant des flancs porosifiés et une partie centrale non porosifiée,
- réaliser une épitaxie d'une structure active comprenant, par exemple, des puits quantiques à base d'InGaN, simultanément sur la première mésa, la deuxième mésa et la troisième mésa, moyennant quoi la structure active sur la première mésa émet à une première longueur d'onde, la structure active sur la deuxième mésa émet à une deuxième longueur d'onde et la structure active sur la troisième mésa émet à une troisième longueur d'onde,

la première longueur d'onde étant supérieure à la deuxième et à la troisième longueur d'onde,
la troisième longueur d'onde étant inférieure à la deuxième longueur d'onde.

Des modes de réalisation particuliers de ce procédé de fabrication selon la présente invention sont l'objet des revendications dépendantes de procédé en annexe.

Selon un mode de réalisation particulier, la couche de protection est en nitrure de silicium.

Selon un mode de réalisation particulier, les pores de la première mésa et/ou de la troisième mésa ont un diamètre supérieur à 20 nm et inférieur à 100 nm.

Selon un mode de réalisation particulier, une couche de protection, de préférence en nitrure de silicium, est disposée sur les flancs de la deuxième mésa et/ou sur le substrat de base entre les mésas.

Selon un mode de réalisation particulier, la structure est obtenue selon les étapes suivantes :
- fournir le substrat de base recouvert par les mésas (Al,In,Ga)N/(Al,In,Ga)N, les mésas comprenant une couche de (Al,In,Ga)N fortement dopée et une couche de (Al,In,Ga)N non dopée ou faiblement dopée,
- déposer une première couche isolante, par exemple en résine, sur la première mésa et sur la deuxième mésa,
- porosifier partiellement la troisième mésa, moyennant quoi la troisième mésa a des flancs porosifiés et une partie centrale non porosifiée,
- retirer la première couche isolante,
- déposer une deuxième couche isolante, par exemple en résine, sur la deuxième mésa et sur la troisième mésa,
- porosifier complètement la première mésa,
- retirer la deuxième couche isolante,
- déposer la couche de protection sur les flancs de la première mésa.

Selon un mode de réalisation particulier, la structure est obtenue selon les étapes suivantes :
- fournir le substrat de base recouvert par un empilement comprenant une couche (Al,In,Ga)N fortement dopée et une couche (Al,In,Ga)N non dopée ou faiblement dopée,
- déposer une couche isolante, par exemple en résine, sur l'empilement au droit de la première mésa et des flancs de la troisième mésa,
- implanter les parties de la couche (Al,In,Ga)N fortement dopée non couvertes par la couche isolante, de manière à diminuer le dopage des zones non couvertes, moyennant quoi la couche (Al,In,Ga)N comprend des zones fortement dopées et des zones non dopées ou faiblement dopées,
- retirer la couche isolante et, de préférence, réaliser un recuit thermique,
- déposer une couche isolante additionnelle, par exemple en résine, des ouvertures étant formées dans la couche isolante additionnelle au droit de la première mésa, de la deuxième mésa et de la troisième mésa,
- graver l'empilement à travers les ouvertures de la couche isolante additionnelle, de manière à former la première mésa, la deuxième mésa et la troisième mésa,
- éventuellement, retirer la couche isolante additionnelle,
- porosifier les zones fortement dopées de la couche (Al,In,Ga)N,
- déposer la couche de protection sur la première mésa.

Ce but est également atteint par un dispositif photonique, selon la revendication 7 en annexe, comprenant un substrat de base recouvert par des mésas (Al,In,Ga)N/(Al,In,Ga)N, une première mésa étant entièrement porosifiée et dont les flancs sont recouverts par une couche de protection par exemple en nitrure de silicium, une deuxième mésa n'étant pas porosifiée et une troisième mésa comprenant des flancs porosifiés et une partie centrale non porosifiée, la première mésa, la deuxième mésa et la troisième mésa étant recouverte, respectivement, par une première structure active émettant à une première longueur d'onde, une deuxième structure active émettant à une deuxième longueur d'onde et une troisième structure active émettant à une troisième longueur d'onde,
la première longueur d'onde étant supérieure à la deuxième et à la troisième longueur d'onde,
la troisième longueur d'onde étant inférieure à la deuxième longueur d'onde.

Des modes de réalisation particuliers de ce dispositif photonique selon la présente invention sont l'objet des revendications dépendantes de produit en annexe.

Selon un mode de réalisation particulier, le dispositif est un micro-écran à émissions natives rouge, vert et bleu.

Selon un mode de réalisation particulier, les longueurs d'onde sont dans l'infrarouge.

Selon un mode de réalisation particulier, le substrat de base comprend une couche support, une première couche de GaN non dopée, éventuellement une couche additionnelle de GaN fortement dopée, et une deuxième couche de GaN dopée.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B, représentent, de manière schématique différentes étapes d'un procédé de fabrication d'un dispositif photonique selon un mode de réalisation particulier de l'invention ;
la figure 2A et la figure 2B, représentent, de manière schématique différentes étapes d'un procédé de fabrication d'un dispositif photonique selon un autre mode de réalisation particulier de l'invention ;
la figure 3A, la figure 3B, la figure 3C et la figure 3D, représentent de manière schématique différentes étapes d'un procédé de porosification de mésas selon un autre mode de réalisation particulier de l'invention ;
la figure 4A, la figure 4B, la figure 4C, la figure 4D, la figure 4E et la figure 4F, représentent de manière schématique différentes étapes d'un procédé de porosification de mésas selon un autre mode de réalisation particulier de l'invention ;
la figure 5 représente, de manière schématique et en coupe, une structure LED épitaxiée sur une mésa non poreuse, selon un mode de réalisation particulier de l'invention ;
la figure 6 est un cliché obtenu au microscope électronique à balayage d'une mésa complètement porosifiée, obtenue selon un mode de réalisation particulier de l'invention ;
la figure 7 est un cliché obtenu au microscope électronique à balayage d'une mésa non porosifiée, obtenue selon un mode de réalisation particulier de l'invention ; et
la figure 8 représente différentes mesures photoluminescence, à température ambiante (typiquement entre 20 et 25°C), sur des mésas poreuses (notées P sur la figure 8) et des mésas non poreuses (notées NP sur la figure 8) sur lesquelles la même structure LED a été épitaxiée au cours de la même épitaxie, selon différents modes de réalisation particulier de l'invention.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf précision contraire, par compris entre X et Y, on entend que les bornes X et Y sont incluses dans la gamme.

Bien que cela ne soit aucunement limitatif, l'invention trouve particulièrement des applications dans le domaine des micro-écrans couleurs, et plus particulièrement pour la fabrication des pixels rouge vert bleu.

Typiquement, une émission dans le vert est à une longueur d'onde comprise entre 500 et 550 nm, une émission dans le rouge est à une longueur d'onde comprise entre 600 et 650 nm et une émission dans le bleu est à une longueur d'onde comprise entre 420 et 480 nm.

L'invention est particulièrement intéressante pour fabriquer des micro-écrans pour la réalité augmentée et virtuelle.

Cependant, elle pourrait être utilisée pour la fabrication de LED ou de laser émettant à grande longueur d'onde. En particulier, l'invention trouve des applications pour les dispositifs fonctionnant dans l'infrarouge court (SWIR pour 'Short-Wave Infrared'). Par infrarouge court, on entend des longueurs d'onde comprises entre 0,7 et 1,7 µm, et notamment entre 0,9 - 1,7 µm.

L'invention est particulièrement intéressante pour des pixels dont les dimensions sont inférieures à 10 µm.

Le procédé est particulièrement intéressant pour fabriquer des structures comprenant des mésas (Al,In,Ga)N/(Al,In,Ga)N ayant, notamment, un pas inférieur à 30 µm.

Par mésa (Al,In,Ga)N/(Al,In,Ga)N, on entend que les mésas comprennent deux couches en (Al,In,Ga)N. Les mésas (Al,In,Ga)N/(Al,In,Ga)N comprennent une couche inférieure 124 en (Al,In,Ga)N et une couche supérieure en (Al,In,Ga)N non dopée ou faiblement dopée 125. La couche supérieure est celle sur laquelle est réalisée l'épitaxie. Elle n'est pas ou peu impactée par l'étape de porosification. Elle reste continue et dense. Elle assure la qualité de la couche épitaxiée, telle qu'une couche d' (In,Ga)N.

Par (Al,In,Ga)N, on entend AlN, AlGaN, InGaN ou GaN. Par la suite, on fait plus particulièrement référence à du GaN poreux, mais avec un tel procédé, il est possible d'avoir, par exemple, de l'InGaN ou de l'AlGaN poreux. La couche dense en InGaN (en compression) ou la couche dense en AlGaN (en tension) va se relaxer grâce à une structure poreuse quelle que soit sa composition. Il est également possible de remplacer le GaN des mésas par un mélange de GaN et de InGaN. Dans ce cas, on aurait du GaN poreux et de l'InGaN poreux, notamment pour la mésa qui va être complètement porosifiée.

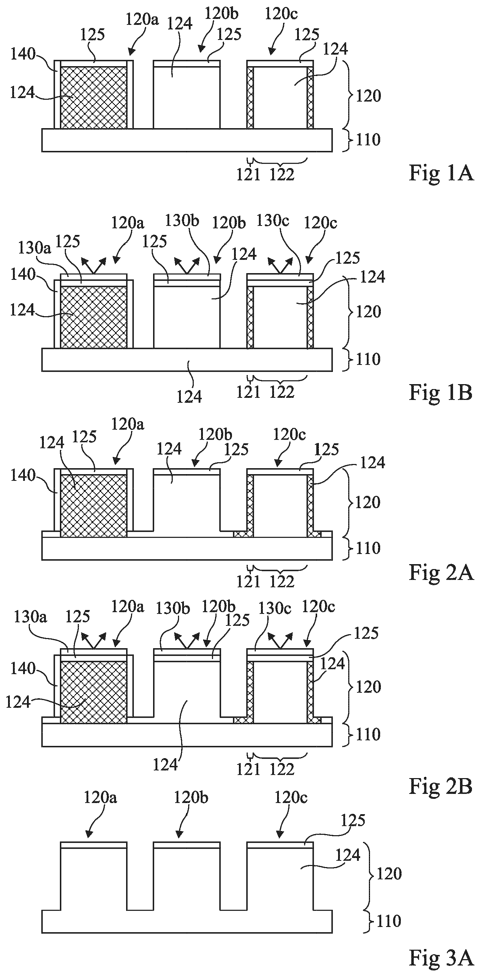

En faisant référence aux figures 1A et 1B et aux figures 2A et 2B, nous allons maintenant décrire plus en détail le procédé de fabrication d'un dispositif photonique. Le procédé comprend au moins les étapes suivantes :
i) fournir une structure comprenant un substrat de base 110 recouvert par des mésas 120 (Al,In,Ga)N/(Al,In,Ga)N, une première mésa 120a étant entièrement porosifiée et ayant ses flancs recouverts par une couche de protection 140, une deuxième mésa 120b n'étant pas porosifiée et une troisième mésa 120c comprenant des flancs 121 porosifiés et une partie centrale 122 non porosifiée (figure 1A, figure 2A),
ii) déposer par épitaxie une structure active 130, typiquement une structure LED, comprenant notamment des puits quantiques 132 à base d'InGaN, simultanément sur la première mésa 120a, la deuxième mésa 120b et la troisième mésa 120c (figure 1B, figure 2B).

La même structure active 130 est déposée simultanément sur les trois mésas 120a, 120b, 120c.

Le taux d'indium incorporé à la surface des mésas 120 est plus ou moins important en fonction, non seulement, du niveau de relaxation de la mésa 120 mais aussi du taux de porosité des flancs 121 des mésas 120. En effet, les pores ont la capacité de piéger les atomes d'indium au moment de la croissance de la couche épitaxiée. Le contrôle de l'exposition des pores aux flux de croissance va permettre de moduler la concentration en indium en surface des mesas. On obtient ainsi après une seule reprise d'épitaxie, trois types de mésas 120a, 120b, 120c émettant à trois longueurs d'onde différentes.

Par complètement porosifiée, on entend que la couche inférieure 124 de la première mésa 120a est entièrement porosifiée : tout son volume est porosifié.

Par non porosifiée, on entend que la couche inférieure 124 de la deuxième mésa 120b n'est pas porosifié.

La troisième mésa 120c est partiellement porosifiée. Les flancs 121 de la couche inférieure 124 de la troisième mésa 120c sont porosifiés et le cœur 122 de la couche inférieure 124 de la troisième mésa 120c n'est pas porosifié.

Pour des raisons de lisibilité, chaque schéma comprend trois mésas, une de chaque type. Il est évident que le substrat de base 110 peut être recouvert par trois groupes de mésas, chaque groupe de mésa comprenant plusieurs mésas d'un des trois types (i.e. un premier groupe de mésas complètement porosifiées 120a, un deuxième groupe de mésas non porosifiées 120b et un troisième groupe de mésas partiellement porosifiées 120c) .

Par flanc, on entend la partie latérale de la couche inférieure des mésas 120. Cette partie s'étend depuis le bord de la couche inférieure des mésas et s'étend sur une épaisseur, par exemple de 50 à 200 nm vers le centre de la mésa (typiquement pour une mésa de 3 µm de largeur). Le rapport entre l'épaisseur du flanc et la largeur de la mésa est, par exemple, compris entre 1 et 20%, de préférence entre 1 et 10%.

Le procédé permet ainsi de moduler l'incorporation de l'indium en fonction du taux de porosification des flancs 121 des mésas 120 et de l'accessibilité des pores sur les flancs des mésas 120.

La première mésa 120a est complètement poreuse et ses flancs 121 sont protégés par la couche de protection 140. Elle donnera, après reprise d'épitaxie de la structure tout InGaN, l'émission à plus grande longueur d'onde car elle permettra le plus fort taux de relaxation de l'InGaN.

La deuxième mésa 120b est non poreuse. Ses flancs peuvent être protégés par une couche de protection ou non protégés. Elle donnera une émission à une longueur d'onde intermédiaire, car la structure sera moins relaxée que la structure de la première mésa 120a.

La troisième mésa 120c a des flancs 121 poreux et un cœur 122 non poreux. Ses flancs 121 ne sont pas protégés par une couche de protection. Elle donnera l'émission à plus courte longueur d'onde car une partie des atomes d'In incidents seront captés par les flancs 121 poreux apparents.

Ainsi, il n'est pas nécessaire d'atteindre un très grand paramètre de maille dans le plan pour l'émission rouge et il est possible d'obtenir les trois couleurs primaires en une seule épitaxie.

Typiquement, un paramètre de maille dans le plan de 3,212 Å est suffisant pour la mésa complètement poreuse 120a émettant dans le rouge (notamment pour des mésas ayant une hauteur d'au moins 800 nm et un diamètre inférieur à 3 µm) contre 3,238 Å comme dans l'art antérieur.

Nous allons maintenant décrire plus en détail les différents éléments formant la structure fournie à l'étape i) et son procédé de fabrication.

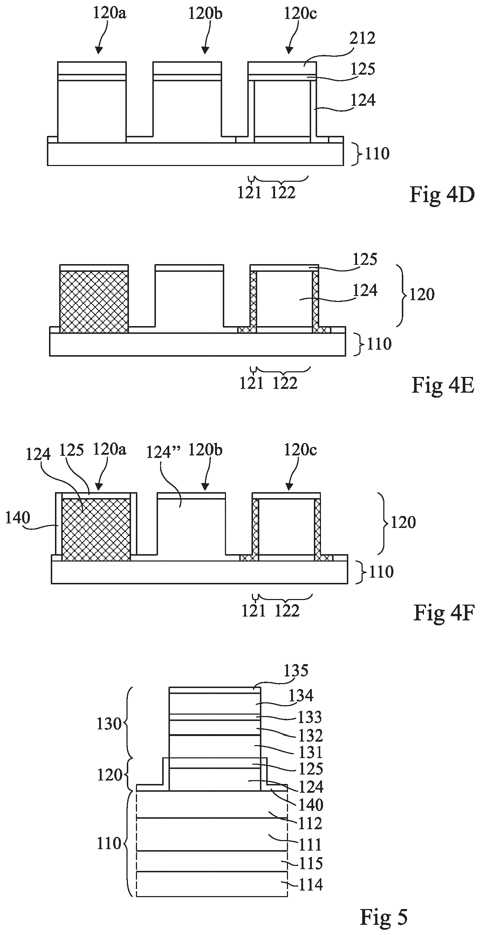

Comme représenté sur la figure 5, la structure fournie à l'étape i) comprend un substrat de base 110 recouvert par des mésas 120 (Al,In,Ga)N/(Al,In,Ga)N.

Le substrat de base 110 comprend successivement :
- un substrat support 114,
- éventuellement une couche tampon 115 en (Al,Ga)N, notamment dans le cas d'une couche support 114 en silicium,
- une première couche de GaN non dopée 111,
- éventuellement une couche additionnelle en GaN fortement dopée (non représentée),
- une deuxième couche de GaN dopée 112.

Les mésas 120 (Al,In,Ga)N/(Al,In,Ga)N disposées sur le substrat de base 110 comprennent une troisième couche en (Al,In,Ga)N 124 (i.e. la couche inférieure de la mésa) et une quatrième couche de (Al,In,Ga)N non dopée ou faiblement dopée 125 (i.e. la couche supérieure de la mésa).

Le substrat support 114 est, par exemple, en saphir ou en silicium.

La couche support 114 a, par exemple, une épaisseur allant de 250µm à 2mm. L'épaisseur dépend de la nature de la couche support 114 et de ses dimensions. Par exemple, pour une couche support en saphir de 2 pouces de diamètre, l'épaisseur peut être de 350 µm. Pour une couche support en saphir de 6 pouces de diamètre, l'épaisseur peut être de 1,3mm. Pour une couche support en silicium de 200mm de diamètre, l'épaisseur peut être 1mm.

Dans le cas d'une couche support 114 en silicium, une couche tampon ('buffer') en (Al,Ga)N est, avantageusement, interposée entre la couche support 114 et la couche non intentionnellement dopée (nid) GaN 111.

La première couche 111 est une couche en GaN nid. C'est une couche non intentionnellement dopée pour ne pas être porosifiée. Par GaN non intentionnellement dopée, on entend une concentration inférieure à 10¹⁷ at/cm³.

La première couche 111 en GaN nid a, par exemple, une épaisseur allant de 500nm à 5µm. Avantageusement, son épaisseur est entre 1 et 4 µm pour absorber les contraintes liées au désaccord de maille entre le GaN et le substrat.

La deuxième couche 112 est une couche en GaN dopée. Par GaN dopée, on entend une concentration, de préférence supérieure à 1.10¹⁷ at/cm³ et de préférence inférieure à 5.10¹⁸ at/cm³ et encore plus préférentiellement inférieure à 1.10¹⁸ at/cm³. La présence des lignes électriquement conductrices permet d'avoir une couche de GaN dont la concentration est inférieure à 5.10¹⁷ at/cm³ et, par exemple entre 1.10¹⁷ at/cm³ et 5.10¹⁷ at/cm³.

Dans la mesure où la deuxième couche dopée 112 recouvre entièrement la couche additionnelle, elle assure la protection de la couche additionnelle fortement dopée sous-jacente de toute porosification, et assure également la prise de contact.

Cette couche est, avantageusement, la plus fine possible (par exemple, elle a une épaisseur comprise entre 400 et 800 nm) tout en restant bien couvrante pour éviter l'infiltration de l'électrolyte et donc la consommation de la couche additionnelle sous-jacente fortement dopée lors de la porosification.

La deuxième couche 112 en GaN a, par exemple, une épaisseur allant de 200nm à 1µm, préférentiellement entre 400 et 700nm. L'épaisseur minimale varie en fonction du taux de dopage.

La couche additionnelle de GaN fortement dopée (non représentée) est disposée entre la première couche 111 de GaN non dopée et la deuxième couche 112 de GaN dopée. La couche additionnelle fortement dopée assure la conduction latérale des charges dans la structure.

La couche additionnelle fortement dopée est, avantageusement, épaisse (typiquement entre 0,5 µm et 5µm et de préférence entre 1 et 2µm). Elle a, par exemple, une épaisseur de 2µm.

Par exemple, le taux de dopage de la couche additionnelle de GaN fortement dopé est compris entre 5.10¹⁸ at/cm³ et 2.10¹⁹ at/cm³, de préférence entre 5.10¹⁸ at/cm³ et 1,5.10¹⁸ at/cm³, encore plus préférentiellement entre 8.10¹⁸ at/cm³ et 1.10¹⁹ at/cm³. Le taux de dopage est, par exemple, de 1.10¹⁹ at/cm³.

La structure comprend ainsi un bicouche ou un tricouche comprenant deux ou trois couches à base de GaN dopé ayant des dopages différents. Le bicouche ou le tricouche est positionné entre la première couche de GaN non dopé 111 du substrat et la quatrième couche de (Al,In,Ga)N 125 non dopé ou faiblement dopé des mésas 120. La deuxième couche 112 a un taux de dopage inférieur à celui de la couche additionnelle, et peut servir à réaliser le contact électrique.

La troisième couche 124 est, au début du procédé de fabrication de la structure fournie à l'étape i), une couche de GaN fortement dopée. Par GaN fortement dopée, on entend une concentration supérieure à 5.10¹⁸ at/cm³, de préférence supérieure à 8.10¹⁸ at/cm³, voire supérieure à 10¹⁹ at/cm³. Elle a, par exemple, un dopage dix fois plus élevé que la deuxième couche 112. Elle a une épaisseur comprise entre 200nm et 2 µm, de préférence de 500 nm à 1µm. De préférence, le dopage de la troisième couche 124 est supérieur d'un facteur 30 voire d'un facteur 100 au dopage de la deuxième couche 112.

Comme nous le verrons par la suite, le dopage de la troisième couche peut être diminué voire supprimé, au niveau du cœur 122 et/ou des flancs 121 de la mésa. La troisième couche est alors complètement ou partiellement non dopée ou faiblement dopée. Par faiblement dopé, on entend un dopage entre 1.10¹⁷ at/cm³ et 5.10¹⁷ at/cm³. Par non dopée, on entend un taux de dopage inférieur à 1.10¹⁷ at/cm³.

De plus, en fonction des mésas et de leur procédé de fabrication, la troisième couche de (Al,In,Ga)N 124 de la structure fournie à l'étape i) peut comprendre :
- un cœur 122 et des flancs 121 fortement dopés porosifiés (première mésa 120a),
- un cœur 122 et des flancs 121 non porosifiés, le cœur 122 et les flancs pouvant être fortement dopés ou non dopés ou faiblement dopés (deuxième mésa 120b),
- un cœur 122 non porosifié et des flancs 121 fortement dopés porosifiés, le cœur pouvant être fortement dopé ou non dopé ou faiblement dopé (troisième mésa).

La quatrième couche 125 est une couche (Al,In,Ga)N non intentionnellement dopée ou faiblement dopée. Par (Al,In,Ga)N faiblement dopé, on entend un dopage entre 1.10¹⁷ at/cm³ et 1.10¹⁸ at/cm³. Par non dopée, on entend un taux de dopage inférieur à 1.10¹⁷ at/cm³.

Il peut s'agir d'une couche en AlN, AlGaN, InGaN ou GaN. Elle a par exemple une épaisseur entre 10nm et 200nm, de préférence entre 50 et 200nm. Le dopage est suffisamment faible de manière à ce que cette couche soit électriquement isolante. Elle n'est pas porosifiée lors de l'étape de porosification.

Cette couche 125 n'est pas ou peu impactée par la porosification et sert de couche de nucléation pour une reprise de croissance. Cette couche 125 est continue pour assurer la qualité de la couche répitaxiée, d'une couche d' (In,Ga)N par exemple, sur la structure.

Selon une autre variante de réalisation, la première partie de la couche tampon n-InGaN 131 de la structure active 130 peut être réalisée avant la formation des mésas 120. Cette première partie peut avoir une épaisseur comprise entre 50 et 200 nm. Cette première partie est ici non intentionnellement dopée (nid). Selon cette variante, il n'est pas nécessaire d'avoir la couche de nid-GaN. La seconde partie de la couche tampon n-InGaN va être formée à la reprise d'épitaxie sur mésas.

Les tensions appliquées lors de la porosification seront choisies en fonction des dopages des différentes couches précitées, et notamment de la deuxième couche 112 et de la troisième couche 124.

En particulier, les taux de dopage respectifs sont choisis pour qu'à potentiel donné, il y ait une sélectivité entre la zone fortement dopée et la zone faiblement dopée. Pour un potentiel donné, le taux de dopage de la deuxième couche 112 est choisi de manière à ce que la deuxième couche 112 ne soit pas porosifiée lors de l'étape de porosification et le taux de dopage de la troisième couche 124 est choisi de manière à ce que la troisième couche 124 soit porosifiée lors de l'étape de porosification.

Les flancs de la première mésa 120a sont recouverts par une couche de protection 140. Il s'agit, par exemple, d'un matériau diélectrique. De préférence, le matériau est un nitrure, encore plus préférentiellement un nitrure de silicium. L'épaisseur de la couche de protection est, par exemple, comprise entre 20 et 100 nm, de préférence entre 20 et 50 nm.

Par la suite, on décrit un dopage de type n, mais il pourrait s'agir d'un dopage de type p. L'homme du métier choisira les paramètres de porosification en fonction du type de dopage.

Les mésas 120, aussi appelées élévations, sont des éléments en relief.

De préférence, les flancs des mésas 120 sont perpendiculaires à cet empilement de couches.

La surface des mésas peut être circulaire, hexagonale, carrée ou rectangulaire. De préférence, elle est circulaire. Le diamètre des mésas est, par exemple, compris entre 3 et 4 µm.

La hauteur des mésas est, par exemple, comprise entre 0,8 et 1,2 µm.

L'épaisseur des mésas correspond à la dimension de la mésa perpendiculaire à l'empilement sous-jacent.

Le pas (ou période des motifs) peut aller de quelques micromètres à quelques dizaines de micromètres. Il est, de préférence, compris entre 50nm et 20µm. Encore plus préférentiellement, il est compris entre 1 et 10 µm. Il est, par exemple, de 5 µm.

La structure fournie à l'étape i) peut être obtenue selon différentes variantes de réalisation.

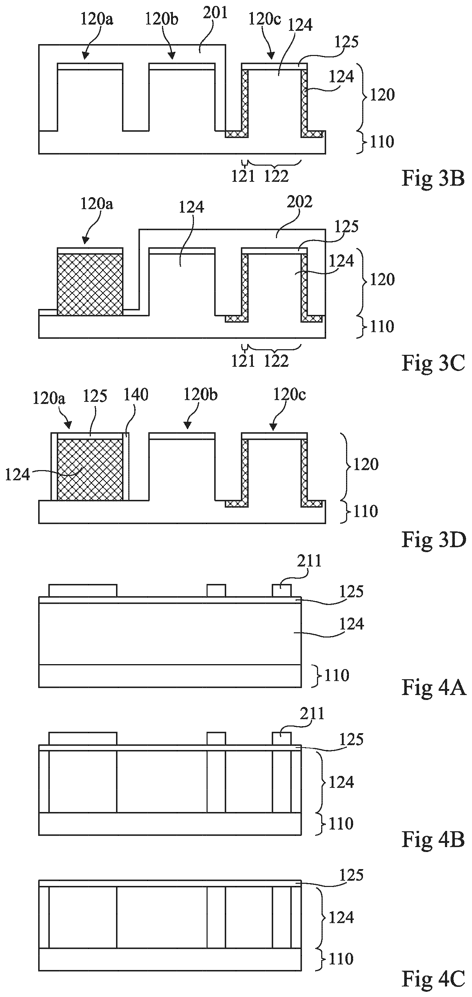

Selon une première variante de réalisation, par exemple représentée sur les figures 3A à 3E, le procédé de porosification de mésas 120 de (Al,In,Ga)N/(Al,In,Ga)N comprend les étapes suivantes :
a) fournir un substrat de base 110 recouvert par des mésas (120) (Al,In,Ga)N/(Al,In,Ga)N non porosifiées (figure 3A), les mésas comprenant une couche de (Al,In,Ga)N 124 dopée recouverte par une couche de (Al,In,Ga)N non dopée 125,
b) déposer une première couche isolante 201, par exemple en résine, sur la première mésa 120a et sur la deuxième mésa 120b,
c) porosifier partiellement la troisième mésa 120c, moyennant quoi la troisième mésa 120c a des flancs 121 porosifiés et une partie centrale 121 non porosifiée (figure 3B),
d) retirer la première couche isolante 201,
e) déposer une deuxième couche isolante 202, par exemple en résine, sur la deuxième mésa 120b et sur la troisième mésa 120c,
f) porosifier complètement la première mésa 120a (figure 3C),
g) retirer la deuxième couche isolante 202,
h) déposer la couche de protection 140 sur la première mésa 120a (figure 3D).

On obtient ainsi la structure de la figure 1A.

Lors de l'étape a), les mésas 120 sont déjà formées. Elles sont obtenues, par exemple, en gravant la quatrième couche 125 et la troisième couche 124. La gravure est réalisée de manière à ne laisser subsister qu'un certain nombre de "reliefs" formés de ces couches.

La gravure est, de préférence, réalisée avec un masque dur qui présente une sélectivité favorable avec la vitesse de gravure des couches de GaN (typiquement avec un rapport de vitesse de gravure > 1/4). Le masque dur est, par exemple, en SiO₂. Après gravure des mésas, ce masque dur est retiré par un procédé chimique humide.

La gravure est, par exemple, une gravure au plasma chloré.

Ainsi, on obtient une structure comprenant un substrat de base 110 surmonté d'une pluralité de mésas 120 en (Al, In, Ga) N/ (Al, In, Ga) N.

Lors de l'étape b), une première couche isolante 201, de préférence en résine, est déposée. Elle est, par exemple déposée, de manière à laisser apparaître la troisième mésa 120c. Elle protège la première mésa 120a et la deuxième mésa 120b.

La résine peut être remplacée par n'importe quel matériau électriquement isolant, pourvu qu'il soit compatible avec les conditions de porosification et avec le niveau de contamination requis par l'équipement d'épitaxie.

Lors de l'étape c), les flancs 121 de la troisième mésa 120c sont porosifiés. La durée est choisie de manière à ne porosifier que les flancs 121 de la mésa. Par exemple, la porosification est réalisée pendant quelques secondes. Ceci conduit à la formation de pores volumineux (typiquement long d'une centaine de nm dans la direction perpendiculaire à l'axe c).

Après retrait de la première couche isolante 201 lors de l'étape d), une deuxième couche isolante 202 (en résine ou un autre matériau isolant) est déposée (étape e)). Elle recouvre la deuxième mésa 120b et la troisième mésa 120c.

Lors de l'étape f), la première mésa 120a est complètement porosifiée. La durée est choisie de manière à porosifier toute la couche 124 de la mésa. Ceci conduit à la formation de pores volumineux (typiquement long d'une centaine de nm dans la direction perpendiculaire à l'axe c).

Lors de l'étape g), la deuxième couche isolante 202 est retirée.

Lors de l'étape h), une couche de protection 140 est déposée sur les flancs de la première mésa 120a et, éventuellement en fond de mésa.

L'ordre des étapes g) et h) peut être inversé.

La couche de protection 140 est déposée sur les flancs de la mésa 120a totalement poreuse, afin de maximiser l'incorporation d'indium au sommet de ces mésas, via la relaxation de l'InGaN obtenue par la porosification des mesas.

Lors de cette étape, la couche de protection 140 peut aussi être déposée sur les flancs de la deuxième mésa 120b non poreuse.

La couche de protection 140 peut être déposée sur le substrat entre les mésas 120. Il est également possible de la déposer sur le substrat en fond de mésas pour les mésas 120a et 120b, mais pas pour les mésas 120c.

Le choix du positionnement de la couche de protection 140 (flancs et fond de mésas) permet de jouer sur l'effet de captage d'indium par les pores.

Avec ce procédé, la première mésa 120a comprend une couche de (Al,In,Ga)N 124 fortement dopée porosifiée.

La deuxième mésa 120b comprend une couche de (Al,In,Ga)N 124 fortement dopée et non porosifiée.

La troisième mésa 120c est partiellement porosifiée. Une partie de la couche de (Al,In,Ga)N 124 est fortement dopée et forme le cœur 122, et l'autre partie de la couche de (Al,In,Ga)N 124 est fortement dopée et porosifiée et forme les flancs 122.

Selon une deuxième variante de réalisation, par exemple représentée sur les figures 4A à 4F, la structure est obtenue selon les étapes suivantes :
a') fournir un substrat de base 110 recouvert par un empilement comprenant une couche (Al,In,Ga)N fortement dopée 124 et une couche (Al,In,Ga)N non dopée 125,
b') déposer une couche isolante 211 sur la couche (Al,In,Ga)N non dopée 125 au droit de la première mésa 120a et des flancs 121 de la troisième mésa 120c (figure 4A),
c') implanter les zones non couvertes par la couche isolante 211, de manière à diminuer leur dopage (figure 4B), moyennant quoi la couche (Al,In,Ga)N 124 comprend des zones fortement dopées et des zones non dopées,
d') réaliser un recuit et retirer la résine 211, (figure 4C),
e') déposer une autre couche isolante 212, par exemple en résine, des ouvertures étant formées dans cette autre couche isolante 212 au droit de la première mésa 120a, de la deuxième mésa 120b et de la troisième mésa 120c,
f') graver l'empilement à travers les ouvertures de la résine 212, de manière à former la première mésa 120a, le deuxième mésa 120b et la troisième mésa 120c (figure 4D),
g') retirer l'autre couche isolante 212,
h') porosifier les zones fortement dopées (figure 4E),
i') déposer la couche de protection 140 sur la première mésa 120a (figure 4F).

Cette deuxième variante est basée sur la mise en œuvre d'une implantation pour réduire voire supprimer le dopage de zones sélectionnées de façon à obtenir des zones fortement dopées et des zones non dopées ou faiblement dopées. Seules les zones fortement dopées seront porosifiées.

Alternativement, il est possible de réaliser une variante de réalisation mettant en œuvre une étape de dopage, par exemple de type n, par implantation. Pour une telle variante, une couche nid est implantée, par exemple avec du silicium, au niveau des zones à porosifier. Un recuit est ensuite réalisé.

Le nombre d'étapes technologiques (dépôt et retrait de la résine notamment) est réduit et la structure finale souhaitée est obtenue en une seule étape de porosification.

Lors de l'étape b'), une couche isolante 211 est déposée. Elle présente des ouvertures au droit des zones que l'on souhaite implanter. Les zones protégées par la couche isolante 211 ne seront pas implantées lors de l'étape c'). Il s'agit par exemple d'une couche de Si₃N₄ pouvant avoir une épaisseur de 20 nm. Elle sera retirée avant la reprise d'épitaxie.

Lors de l'étape c'), une implantation est réalisée. Les zones implantées seront alors dé-dopées. Par exemple, pour des couches dopées n, il est possible d'implanter de l'hélium pour rendre ces zones moins dopées ou non dopées.

Lors de l'étape d'), un recuit est réalisé. Le recuit permet de guérir les défauts créés au cours de l'implantation. Ces défauts pourraient modifier le taux de porosification lors de l'étape h').

Lors de l'étape e'), une autre couche isolante 212 est déposée. Des ouvertures sont formées dans la résine au droit de la première mésa 120a, de la deuxième mésa 120b et de la troisième mésa 120c.

Puis lors de l'étape f'), l'empilement est gravé pour former les mésas 120.

L'étape g') peut être réalisée après l'étape h') ou après l'étape i').

Lors de l'étape h'), une porosification est réalisée. Grâce à la modulation du dopage par implantation, seule les parties non implantées sont porosifiées, on obtient donc les trois types de mésas 120 souhaités (i.e. une première mésa 120a totalement poreuse, une deuxième mésa 120b non poreuse, une troisième mésa 120c ayant un centre non poreux et des flancs poreux). La durée est choisie de manière à porosifier complètement la première mésa 120a.

Lors de l'étape i'), une couche de protection 140 est déposée sur les flancs de la première mésa 120a poreuse. Ceci permet de maximiser l'incorporation d'indium au sommet de ces mésas au cours de l'épitaxie de la zone active (LED).

Une couche de protection peut aussi être déposée ou non sur les flancs de la deuxième mésa 120b non poreuse et/ou entre les mésas.

On obtient ainsi la structure représentée sur la figure 2A.

Avec ce procédé, la couche de (Al,In,Ga)N 124 de la première mésa est une couche porosifiée.

La couche de (Al,In,Ga)N 124 de la deuxième mésa 120b est une couche non porosifiée.

Pour la troisième mésa, les flancs 121 de la couche de (Al,In,Ga)N 124 sont porosifiés. Le cœur 122 de la couche de (Al,In,Ga)N 124 n'est pas porosifié.

Pour les différentes variantes de réalisation, les différentes étapes de porosification décrites précédemment peuvent être réalisées selon les sous-étapes suivantes :
- relier électriquement la structure 100 et une contre-électrode à un générateur de tension ou de courant,
- plonger la structure et la contre-électrode dans une solution électrolytique,
- appliquer une tension ou un courant entre la deuxième couche de GaN dopée 112 et la contre-électrode de manière à porosifier partiellement ou totalement la troisième couche de (Al,In,Ga)N fortement dopée 124 des mésas 120.

La structure et une contre-électrode (CE) sont électriquement reliées à un générateur de tension ou de courant. Le dispositif joue le rôle d'électrode de travail (WE). Par la suite, on le dénommera générateur de tension, mais il pourrait s'agir d'un générateur de courant permettant d'appliquer un courant entre le dispositif et la contre-électrode.

La prise de contact est réalisée sur la structure.

En particulier, la prise de contact peut être réalisée sur le substrat de base 110. La reprise de contact peut être réalisée sur la deuxième couche de GaN dopée 112. La reprise de contact peut être faite sur le fond des mésas, au niveau de la deuxième couche 112, ce qui permet d'utiliser l'étape de gravure pour réaliser également les prises de contact. Alternativement, il est possible de réaliser la reprise de contact sur les lignes électriquement conductrices.

Il est également possible de prendre contact sur une des autres couches : sur la quatrième couche de (Al,In,Ga)N faiblement dopée 125 ou sur la troisième couche de (Al,In,Ga)N fortement dopée 124. Dans le cas d'une reprise de contact sur la couche fortement dopée, son ouverture sera, avantageusement, limitée à une zone préservée de l'électrolyte.

La zone de reprise de contact peut également être surmontée d'une couche métallique afin d'améliorer le contact pour la polarisation électrochimique. Ce contact sera retiré après la porosification avant la reprise d'épitaxie.

La contre-électrode est en un matériau électriquement conducteur, comme par exemple un métal de grande surface développée et inerte à la chimie de l'électrolyte tel qu'un grillage en platine.

Les électrodes sont plongées dans un électrolyte, aussi appelé bain électrolytique ou solution électrolytique. L'électrolyte peut être acide ou basique. L'électrolyte est, par exemple, de l'acide oxalique. Il peut également s'agir de KOH, HF, HNO₃, NaNO₃ ou H₂SO₄.

La tension appliquée entre la structure et la contre-électrode peut aller de 1 à 50V par exemple. De préférence, elle est de 7 à 16V. La tension est choisie en fonction des taux de dopage des différentes couches, afin d'obtenir la sélectivité recherchée. Elle est appliquée, par exemple, pendant une durée allant de quelques secondes à plusieurs heures.

Un suivi de la courbe de chrono-ampérométrie au cours de la porosification permet de voir une diminution significative du courant lorsque la couche que l'on souhaite porosifier est totalement porosifiée.

Par exemple, l'étape de porosification est réalisée en appliquant une tension dans une solution d'acide oxalique. L'arrêt du processus est contrôlé avec la chute de courant.

L'étape d'anodisation électrochimique peut être réalisée sous lumière ultraviolette (UV).

La plus grande dimension (la hauteur) des pores peut varier de quelques nanomètres à quelques micromètres. La plus petite dimension (le diamètre) peut varier de quelques nanomètres à une centaine de nanomètres, en particulier de 30 à 70nm.

La porosification obtenue (taux de porosité et taille des pores) dépend du dopage de la couche et des paramètres du procédé (tension appliquée, durée, nature et concentration de l'électrolyte, post-traitement chimique ou recuit). La variation de la porosification permet de contrôler le taux d'incorporation / ségrégation. La porosification, et en particulier, la taille des pores, pourra varier ultérieurement, lors de la reprise d'épitaxie en fonction de la température appliquée.

Les mésas 120 d'une même plaque sont ainsi porosifiées, que ce soit pour des substrats de faibles ou moyennes dimensions ou pour des substrats de grandes dimensions.

Le fond des mésas peut être préservé de la porosification ou porosifié.

Lors de l'étape ii), on réalise une épitaxie sur les mésas 120, moyennant quoi on obtient une couche épitaxiée au moins partiellement relaxée, et de préférence totalement relaxée.

Le pourcentage de relaxation correspond à :
$Δa / a = \left({a}_{c 2}-{a}_{c 1}\right) / {a}_{c 1}$
avec a_{c1}, le paramètre de maille de la couche de départ sur laquelle on reprend l'épitaxie (c'est-à-dire le paramètre de maille de la couche 125), et
a_{c2} le paramètre de maille de la couche relaxée,

La couche est relaxée à 100% si ac₂ correspond au paramètre de maille du matériau massif, de même composition que la couche réépitaxiée.

Lorsque a_{c1}=a_{c2} la couche est dite contrainte.

Par partiellement relaxée, on entend un pourcentage de relaxation supérieur à 50%.

La reprise d'épitaxie peut servir, par exemple, pour former des LED ré-épitaxiées.

La reprise d'épitaxie est réalisée sur la quatrième couche 125 de (Al,In,Ga)N/(Al,In,Ga)N nid ou faiblement dopée des mésas 120. Comme cette couche n'est pas porosifiée lors de l'étape d'anodisation électrochimique, elle reste continue et dense. La reprise d'épitaxie est ainsi facilitée et la couche épitaxiée présente une meilleure tenue. La création de défauts liées à la coalescence des pores est évitée.

La couche épitaxiée lors de cette étape est, avantageusement, en nitrure de gallium ou en nitrure d'indium et de gallium.

Le même procédé d'épitaxie (i.e. les mêmes conditions d'épitaxie) est appliqué sur les 3 mésas, générant ainsi 3 structures différentes émettant à 3 longueurs d'onde différentes.

Les conditions d'épitaxie sont, par exemple, choisies pour générer une structure LED verte tout InGaN sur les mésas 120b. Ces mêmes conditions vont générer d'autres structures sur les mésas voisines. Les trois mésas n'auront pas la même structure finale (épaisseur, concentration d' indium, longueur d'onde d'émission différente).

Il s'agit notamment d'une structure LED tout InGaN. La structure LED 130 comprend, par exemple, une couche tampon de n-InGaN 131, une zone active 132 InGaN/(Ga,In)N comprenant des puits quantiques (PQs, également connus sous l'abréviation: QWs pour 'quantum wells'), une couche de p-InGaN 134 et une couche InGaN fortement dopée 135. Les conditions de croissance sont adaptées pour obtenir la longueur d'onde désirée. En particulier, on choisira des conditions de croissance pour obtenir une émission verte sur la deuxième mésa non poreuse.

Comme représenté sur la figure 5, la structure LED 130 sur la mesa 120 comprend, par exemple, les couches suivantes :
- une couche tampon 131 InₓGa₁₋ₓN dopée n avec x compris entre 7 et 8 % (ayant par exemple une épaisseur de 400 nm),
- une zone active 132 comprenant des puits quantiques, la zone active comprenant par exemple un multicouche 5 x In_{y}Ga_{1-y}N/InₓGa₁₋ₓN avec y = 25 %(ayant par exemple des épaisseurs de 2,5nm/6nm),
- une couche de AlGaN dopée p 133 ('electron blocking layer' (EBL)) (ayant par exemple une épaisseur de 20 nm),
- une couche de InGaN dopée p 134 (ayant par exemple une épaisseur de 150 nm),
- une couche de InGaN dopée p++ 135 (ayant par exemple une épaisseur de 20 nm).

La modulation de l'incorporation de l'indium d'un type de mésa à l'autre est possible grâce à l'exposition ou non des zones poreuses aux flux incidents. Les pores piègent notamment une partie des atomes d'indium.

Comme, d'une part, le pourcentage de porosification est différent dans chaque mésa, et, d'autre part, l'accessibilité des pores diffère, la quantité d'indium incorporée sera différente. Ainsi, la première structure LED 130a sur la première mésa 120a émet à une première longueur d'onde, la deuxième structure LED 130b sur la deuxième mésa 120b émet à une deuxième longueur d'onde et la troisième structure LED 130c sur la troisième mésa 120c émet à une troisième longueur d'onde. La première longueur d'onde est supérieure à la deuxième et à la troisième longueur d'onde. La troisième longueur d'onde est inférieure à la deuxième longueur d'onde.

Les températures mises en œuvre lors de l'épitaxie sont, par exemple, comprises entre 700 et 850°C. De préférence, elles sont comprises entre 750 et 850 °C pour le n-InGaN et p-InGaN, entre 700 et 800°C pour les puits quantiques de la zone active, et entre 750 et 850°C pour les barrières de la zone active.

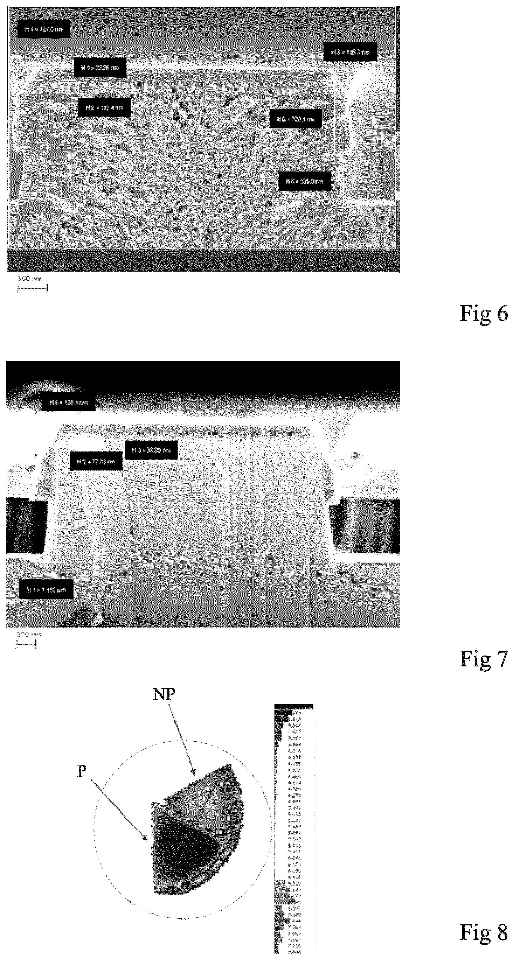

A titre illustratif et non limitatif, la concentration en In de la couche d'InGaN épitaxiée sur des mésas poreuses (figure 6) dont les pores des flancs et de l'inter mésas sont apparents et sur des mésas non poreuses (figure 7) ont été comparés. Pour les mésas poreuses, une concentration en In de 3% est obtenu, et pour les mésas non poreuses plus de 6% d'indium. Un facteur 2 est observé pour une même épitaxie. Ce n'est pas le cas si une couche de protection ('liner') en SiN protège les flancs des mésas poreuses et l'inter mésas.

Ces observations ont été confirmées par des mesures de photoluminescence sur les deux types d'échantillons à température ambiante (figure 8).

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus. L'étendue de la présente invention est définie par les revendications qui suivent.

## Revendications

1. Procédé de fabrication d'un dispositif photonique comprenant les étapes suivantes :
- fournir une structure comprenant un substrat de base (110) recouvert par des mésas (120) (Al, In,Ga)N/(Al, In,Ga)N, une première mésa (120a) étant entièrement porosifiée et ayant des flancs recouverts par une couche de protection (140), une deuxième mésa (120b) étant non porosifiée et une troisième mésa (120c) comprenant des flancs porosifiés (121) et une partie centrale (122) non porosifiée,
- réaliser une épitaxie d'une structure active (130) comprenant, par exemple, des puits quantiques (132) à base d'InGaN, simultanément sur la première mésa (120a), la deuxième mésa (120b) et la troisième mésa (120c), moyennant quoi la structure active (130a) sur la première mésa (120a) émet à une première longueur d'onde, la structure active (130b) sur la deuxième mésa (120b) émet à une deuxième longueur d'onde et la structure active (130c) sur la troisième mésa (120c) émet à une troisième longueur d'onde, la première longueur d'onde étant supérieure à la deuxième et à la troisième longueur d'onde,
la troisième longueur d'onde étant inférieure à la deuxième longueur d'onde.

2. Procédé selon la revendication 1, dans lequel la couche de protection (140) est en nitrure de silicium.

3. Procédé selon l'une des revendications 1 et 2, dans lequel les pores de la première mésa (120a) et/ou de la troisième mésa (120c) ont un diamètre supérieur à 20 nm et inférieur à 100 nm.

4. Procédé selon l'une des revendications 1 à 3, dans lequel une couche de protection, de préférence en nitrure de silicium, est disposée sur les flancs de la deuxième mésa (120b) et/ou sur le substrat de base entre les mésas (120).

5. Procédé selon l'une des revendications 1 à 4, dans lequel la structure est obtenue selon les étapes suivantes :
- fournir le substrat de base (110) recouvert par les mésas (120) (Al,In,Ga)N/(Al,In,Ga)N, les mésas comprenant une couche de (Al,In,Ga)N fortement dopée (124) et une couche de (Al,In,Ga)N non dopée ou faiblement dopée (125),
- déposer une première couche isolante (201), par exemple en résine, sur la première mésa (120a) et sur la deuxième mésa (120b),
- porosifier partiellement la troisième mésa (120c), moyennant quoi la troisième mésa (120c) a des flancs porosifiés (121) et une partie centrale non porosifiée (122),
- retirer la première couche isolante (201),
- déposer une deuxième couche isolante (202), par exemple en résine, sur la deuxième mésa (120b) et sur la troisième mésa (120c),
- porosifier complètement la première mésa (120a),
- retirer la deuxième couche isolante (202),
- déposer la couche de protection (140) sur les flancs de la première mésa (120a).

6. Procédé selon l'une des revendications 1 à 4, dans lequel la structure est obtenue selon les étapes suivantes :
- fournir le substrat de base (110) recouvert par un empilement comprenant une couche (Al,In,Ga)N fortement dopée (124) et une couche (Al,In,Ga)N non dopée ou faiblement dopée (125),
- déposer une couche isolante (211), par exemple en résine, sur l'empilement au droit de la première mésa (120a) et des flancs de la troisième mésa (120c),
- implanter les parties de la couche (Al,In,Ga)N fortement dopée (124) non couvertes par la couche isolante (211), de manière à diminuer le dopage des zones non couvertes, moyennant quoi la couche (Al,In,Ga)N comprend des zones fortement dopées et des zones non dopées ou faiblement dopées,
- retirer la couche isolante (211) et, de préférence, réaliser un recuit thermique,
- déposer une couche isolante additionnelle (212), par exemple en résine, des ouvertures étant formées dans la couche isolante additionnelle (212) au droit de la première mésa (120a), de la deuxième mésa (120b) et de la troisième mésa (120c),
- graver l'empilement à travers les ouvertures de la couche isolante additionnelle (212), de manière à former la première mésa (120a), la deuxième mésa (120b) et la troisième mésa (120c),
- éventuellement, retirer la couche isolante additionnelle (212),
- porosifier les zones fortement dopées de la couche (Al, In, Ga) N,
- déposer la couche de protection (140) sur la première mésa (120a).

7. Dispositif photonique comprenant un substrat de base (110) recouvert par des mésas (120) (Al,In,Ga)N/(Al,In,Ga)N, une première mésa (120a) étant entièrement porosifiée et dont les flancs sont recouverts par une couche de protection (140) par exemple en nitrure de silicium, une deuxième mésa (120b) n'étant pas porosifiée et une troisième mésa (120c) comprenant des flancs (121) porosifiés et une partie centrale (122) non porosifiée, la première mésa (120a), la deuxième mésa (120b) et la troisième mésa (120c) étant recouverte, respectivement, par une première structure active (130a) émettant à une première longueur d'onde, une deuxième structure active (130b) émettant à une deuxième longueur d'onde et une troisième structure active (130c) émettant à une troisième longueur d'onde,
la première longueur d'onde étant supérieure à la deuxième et à la troisième longueur d'onde,
la troisième longueur d'onde étant inférieure à la deuxième longueur d'onde.

8. Dispositif selon la revendication 7, le dispositif étant un micro-écran à émissions natives rouge, vert et bleu.

9. Dispositif selon la revendication 7, dans lequel les longueurs d'onde sont dans l'infrarouge.

10. Dispositif selon l'une des revendications 7 à 9, dans lequel le substrat de base (110) comprend une couche support (114), une première couche de GaN non dopée (111), éventuellement une couche additionnelle de GaN fortement dopée, et une deuxième couche de GaN dopée (112).

## Patentansprüche

1. Verfahren zur Herstellung einer photonischen Einrichtung, das die folgenden Schritte aufweist:
- Bereitstellen einer Struktur, die ein Basis-Substrat (110) aufweist, das von (Al, In, Ga)N/(Al, In, Ga)N-Mesas (120) bedeckt ist,
wobei eine erste Mesa (120a) vollständig porosifiziert ist und Flanken aufweist, die von einer Schutz-Schicht (140) bedeckt sind, eine zweite Mesa (120b) nicht porosifiziert ist und eine dritte Mesa (120c) porosifizierte Flanken (121) und einen nicht-porosifizierten zentralen Abschnitt (122) aufweist,
- epitaktisches Wachsen einer aktiven Struktur (130), die beispielsweise InGaN-basierte Quantentöpfe (132) aufweist, gleichzeitig auf der ersten Mesa (120a), der zweiten Mesa (120b) und der dritten Mesa (120c), wobei die aktive Struktur (130a) auf der ersten Mesa (120a) bei einer ersten Wellenlänge emittiert, die aktive Struktur (130b) auf der zweiten Mesa (120b) bei einer zweiten Wellenlänge emittiert und die aktive Struktur (130c) auf der dritten Mesa (120c) bei einer dritten Wellenlänge emittiert,
die erste Wellenlänge größer als die zweite Wellenlänge und die dritte Wellenlänge ist,
die dritte Wellenlänge kürzer als die zweite Wellenlänge ist.

2. Verfahren nach Anspruch 1, wobei die Schutz-Schicht (140) aus Silizium-Nitrid besteht.

3. Verfahren nach einem der Ansprüche 1 und 2, wobei die Poren der ersten Mesa (120a) und/oder der dritten Mesa (120c) einen Durchmesser von mehr als 20 nm und weniger als 100 nm aufweisen.

4. Verfahren nach einem der Ansprüche 1 bis 3, wobei eine Schutz-Schicht, vorzugsweise aus Silizium-Nitrid, auf den Flanken der zweiten Mesa (120b) und/oder auf dem Basis-Substrat zwischen den Mesas (120) angeordnet ist.

5. Verfahren nach einem der Ansprüche 1 bis 4, wobei die Struktur gemäß den folgenden Schritten erhalten wird:
- Bereitstellen eines Basis-Substrats (110), das von (Al, In, Ga)N/(Al, In, Ga)N-Mesas (120) bedeckt ist, wobei die Mesas eine stark-dotierte (Al, In, Ga)N-Schicht (124) und eine undotierte oder schwach-dotierte (Al, In, Ga)N-Schicht (125) aufweisen,
- Abscheiden einer ersten Isolier-Schicht (201), beispielsweise aus Harz, auf der ersten Mesa (120a) und auf der zweiten Mesa (120b),
- teilweises Porosifizieren der dritten Mesa (120c), wodurch die dritte Mesa (120c) porosifizierte Flanken (121) und einen nicht-porosifizierten zentralen Abschnitt (122) aufweist,
- Entfernen der ersten Isolier-Schicht (201),
- Abscheiden einer zweiten Isolier-Schicht (202), beispielsweise aus Harz, auf der zweiten Mesa (120b) und auf der dritten Mesa (120c),
- vollständiges Porosifizieren der ersten Mesa (120a),
- Entfernen der zweiten Isolier-Schicht (202),
- Abscheiden der Schutz-Schicht (140) auf den Flanken der ersten Mesa (120a).

6. Verfahren nach einem der Ansprüche 1 bis 4, wobei die Struktur gemäß den folgenden Schritten erhalten wird:
- Bereitstellen eines Basis-Substrats (110), das von einem Stapel bedeckt ist, der eine stark-dotierte (Al, In, Ga)N-Schicht (124) und eine undotierte oder schwach-dotierte (Al, In, Ga)N-Schicht (125) aufweist,
- Abscheiden einer Isolier-Schicht (211), beispielsweise aus Harz, auf dem Stapel in Ausrichtung mit der ersten Mesa (120a) und mit den Flanken der dritten Mesa (120c),
- Implantieren der Teile der stark-dotierten (Al, In, Ga)N-Schicht (124), die nicht von der Isolier-Schicht (211) bedeckt sind, um die Dotierung der unbedeckten Bereiche zu verringern, wodurch die (Al, In, Ga)N-Schicht stark-dotierte Bereiche und undotierte oder schwach-dotierte Bereiche aufweist,
- Entfernen der Isolier-Schicht (211) und vorzugsweise Durchführen eines thermischen Temperns,
- Abscheiden einer zusätzlichen Isolier-Schicht (212), beispielsweise aus Harz, wobei Öffnungen in der zusätzlichen Isolier-Schicht (212) in Ausrichtung mit der ersten Mesa (120a), der zweiten Mesa (120b) und der dritten Mesa (120c) ausgebildet werden,
- Ätzen des Stapels durch die Öffnungen in der zusätzlichen Isolier-Schicht (212), um die erste Mesa (120a), die zweite Mesa (120b) und die dritte Mesa (120c) auszubilden,
- optionales Entfernen der zusätzlichen Isolier-Schicht (212),
- Porosifizieren der stark-dotierten Bereiche der (AI, In, Ga)N-Schicht,
- Abscheiden der Schutz-Schicht (140) auf der ersten Mesa (120a).

7. Photonische Einrichtung, die ein Basis-Substrat (110) aufweist, das von (Al, In, Ga)N/ (Al, In, Ga)N-Mesas (120) bedeckt ist,
wobei eine erste Mesa (120a) vollständig porosifiziert ist und Flanken aufweist, die vorzugsweise von einer Schutz-Schicht (140) bedeckt sind, die beispielsweise aus Silizium-Nitrid besteht, eine zweite Mesa (120b) nichtporosifiziert ist und eine dritte Mesa (120c) porosifizierte Flanken (121) und einen nicht-porosifizierten zentralen Abschnitt (122) aufweist,
wobei die erste Mesa (120a), die zweite Mesa (120b) und die dritte Mesa (120c) jeweils von einer ersten aktiven Struktur (130a), die bei einer ersten Wellenlänge emittiert, einer zweiten aktiven Struktur (130b), die bei einer zweiten Wellenlänge emittiert, und einer dritten aktiven Struktur (130c), die bei einer dritten Wellenlänge emittiert, bedeckt sind,
die erste Wellenlänge größer als die zweite und als die dritte Wellenlänge ist, die dritte Wellenlänge kürzer als die zweite Wellenlänge ist.

8. Einrichtung nach Anspruch 7, wobei die Einrichtung ein Mikrodisplay mit nativen roten, grünen und blauen Emissionen ist.

9. Einrichtung nach Anspruch 7, wobei die Wellenlängen im Infrarotbereich liegen.

10. Einrichtung nach einem der Ansprüche 7 bis 9, wobei das Basis-Substrat (110) eine Träger-Schicht (114), eine erste undotierte GaN-Schicht (111), optional eine zusätzliche stark-dotierte GaN-Schicht und eine zweite dotierte GaN-Schicht (112) aufweist.

## Claims

1. Method of manufacturing a photonic device comprising the following steps:
- providing a structure comprising a base substrate (110) covered by (Al,In,Ga)N/(Al,In,Ga)N mesas (120), a first mesa (120a) being fully porosified and having flanks covered by a protective layer (140), a second mesa (120b) being non-porosified, and a third mesa (120c) comprising porosified flanks (121) and a non-porosified central portion (122),
- epitaxially growing an active structure (130) comprising, for example, InGaN-based quantum wells (132), simultaneously on the first mesa (120a), the second mesa (120b), and the third mesa (120c), whereby the active structure (130a) on the first mesa (120a) emits at a first wavelength, the active structure (130b) on the second mesa (120b) emits at a second wavelength, and the active structure (130c) on the third mesa (120c) emits at a third wavelength,
the first wavelength being greater than the second and than the third wavelength,
the third wavelength being shorter than the second wavelength.

2. Method according to claim 1, wherein the protective layer (140) is made of silicon nitride.

3. Method according to one of claims 1 and 2, wherein the pores of the first mesa (120a) and/or of the third mesa (120c) have a diameter greater than 20 nm and smaller than 100 nm.

4. Method according to one of claims 1 to 3, wherein a protective layer, preferably made of silicon nitride, is arranged on the flanks of the second mesa (120b) and/or on the base substrate between the mesas (120).

5. Method according to any of claims 1 to 4, wherein the structure is obtained according to the following steps:
- providing a base substrate (110) covered by (Al,In,Ga)N/(Al,In,Ga)N mesas (120), the mesas comprising a heavily-doped (Al,In,Ga)N layer (124) and an undoped or lightly-doped (Al,In,Ga)N layer (125),
- depositing a first insulating layer (201), for example made of resin, on the first mesa (120a) and on the second mesa (120b),
- partially porosifying the third mesa (120c), whereby the third mesa (120c) has porosified flanks (121) and a non-porosified central portion (122),
- removing the first insulating layer (201),
- depositing a second insulating layer (202), for example made of resin, on the second mesa (120b) and on the third mesa (120c),
- fully porosifying the first mesa (120a),
- removing the second insulating layer (202),
- depositing the protective layer (140) on the sides of the first mesa (120a).

6. Method according to one of claims 1 to 4, wherein the structure is obtained according to the following steps:
- providing a base substrate (110) covered by a stack comprising a heavily-doped (Al,In,Ga)N layer (124) and an undoped or lightly-doped (Al,In,Ga)N layer (125),
- depositing an insulating layer (211), for example made of resin, on the stack in line with the first mesa (120a) and with the flanks of the third mesa (120c),
- implanting the parts of the heavily-doped (Al,In,Ga)N layer (124) not covered by the insulating layer (211), so as to decrease the doping of the uncovered areas, whereby the (Al,In,Ga)N layer comprises heavily-doped areas and undoped or lightly-doped areas,
- removing the insulating layer (211), and preferably, performing a thermal anneal,
- depositing an additional insulating layer (212), for example made of resin, openings being formed in the additional insulating layer (212) in line with the first mesa (120a), the second mesa (120b), and the third mesa (120c),
- etching the stack through the openings in the additional insulating layer (212) so as to form the first mesa (120a), the second mesa (120b), and the third mesa (120c),
- optionally, removing the additional insulating layer (212),
- porosifying the heavily-doped areas of the (Al,In,Ga)N layer,
- depositing the protective layer (140) on the first mesa (120a).

7. Photonic device comprising a base substrate (110) covered by (Al,In,Ga)N/(Al,In,Ga)N mesas (120),
a first mesa (120a) being fully porosified and having its flanks preferably covered by a protective layer (140), for example made of silicon nitride, a second mesa (120b) being non-porosified, and a third mesa (120c) comprising porosified flanks (121) and a non-porosified central portion (122),
the first mesa (120a), the second mesa (120b), and the third mesa (120c) being covered, respectively, by a first active structure (130a) emitting at a first wavelength, a second active structure (130b) emitting at a second wavelength, and a third active structure (130c) emitting at a third wavelength,
the first wavelength being greater than the second and than the third wavelength,
the third wavelength being shorter than the second wavelength.

8. Device according to claim 7, the device being a microdisplay with native red, green, and blue emissions.

9. Device according to claim 7, wherein the wavelengths are in infrared.

10. Device according to one of claims 7 to 9, wherein the base substrate (110) comprises a support layer (114), a first undoped GaN layer (111), optionally an additional heavily-doped GaN layer, and a second doped GaN layer (112).
